# EUROPEAN PATENT APPLICATION

(11) **EP 4 845 025 A1**
(43) Date of publication of application: **25.11.2026**
(21) Application number: 26178728.7
(22) Date of filing: 13.05.2026
(51) Int. Cl.: H03F 1/02, H03F 1/56, H03F 3/24, H03F 3/195

(54) **COMPACT WIDEBAND DOHERTY POWER AMPLIFIER WITH DISTRIBUTING IMPEDANCE CIRCUITRY**

(30) Priority: 14.05.2025 US 202519208487
(71) Applicant: NXP USA, Inc, Austin, TX 78735 (US)
(72) Inventor: Wu, Yu-Ting David, 5656AG Eindhoven (NL); Maalouf, Elie A., 5656AG Eindhoven (NL); You, Yu, 5656AG Eindhoven (NL)
(74) Representative: Schwarzweller, Thomas

(57) **Abstract**

A Doherty power amplifier circuit includes an amplifier circuit including a first terminal and a second terminal and includes a printed circuit board (PCB) coupled to the first terminal and the second terminal. The PCB may include a first impedance circuit coupled between the first terminal and an output terminal, a second impedance circuit coupled between the second terminal and a node, and a third impedance circuit coupled between the node and the output terminal. The first impedance circuit and a portion of the amplifier circuit define a first impedance that corresponds to a selected output impedance at back-off operation. The second impedance circuit and a portion of the amplifier circuit define a second impedance. The first impedance, the second impedance, and a third impedance of the third impedance circuit operate with the amplifier IC to form a Doherty power amplifier with a selected output impedance.

## Description

### FIELD OF USE

The present disclosure generally relates to wideband Doherty power amplifiers, and more particularly to a compact wideband Doherty power amplifier with impedance circuitry that is distributed between a portion of an amplifier integrated circuit and one or more other circuits, which may be coupled to a printed circuit board (PCB).

### BACKGROUND

Wireless communications systems utilize power amplifiers for increasing the power of radio frequency (RF) signals. The power amplifier circuit may form a portion of a last amplification stage in a transmission path before transmission of the RF signal via an antenna. Preferably, such power amplifiers exhibit high gain, high linearity, and stability over a range of frequencies.

Power amplifiers may operate at maximum power efficiency when the power amplifier transmits close to saturated power, and power efficiency may worsen as the power output decreases. Doherty power amplifier architectures have been adopted for base stations and mobile terminals because of the architecture's high-power efficiency over a wide power dynamic range.

Conventional Doherty power amplifier architectures may present challenges to efforts toward reducing semiconductor package sizes. For massive multi-input multi-output (mMIMO) architectures used in fifth generation (5G) antenna systems, stringent circuit footprint requirements for have led to design trade-offs for Doherty power amplifier architectures.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.
FIG. 1 depicts a diagram of a device including an amplifier integrated circuit and a printed circuit board including impedance circuitry configured to provide a Doherty amplifier device, in accordance with certain embodiments.
FIG. 2 depicts a diagram of a device including an amplifier integrated circuit and a substrate including impedance circuitry configured to provide a Doherty amplifier device, in accordance with certain embodiments.
FIG. 3 depicts a diagram of a device including an amplifier integrated circuit (IC) coupled to a PCB with impedance circuitry configured to provide a Doherty amplifier, in accordance with certain embodiments.
FIG. 4 depicts a flow diagram of a method of designing a Doherty power amplifier including distributed impedance circuitry, in accordance with certain embodiments.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

### DETAILED DESCRIPTION

Embodiments described herein are directed to radio frequency (RF) signal amplifier devices. For example, the embodiments described herein may be implemented in two-way Doherty amplifier modules. In general, a Doherty amplifier may include a splitter circuit configured to receive an input signal and to divide the input signal into two output signals, which may be balanced, or which may be divided according to a predetermined ratio. A first signal may be provided to an input of a carrier (main) amplifier and a second signal may be provided to a peaking amplifier. The output of the carrier amplifier may be provided to an input of a first impedance circuit, which may include an output coupled to a summing node. The output of the peaking amplifier may be provided to an input of a second impedance circuit, which may include an output coupled to a node. The Doherty amplifier may include a third impedance circuit coupled between the node and the summing node. The summing node may be coupled to the circuit output by a transformer.

When the Doherty amplifier is constructed on an integrated circuit die, the impedance circuitry may be configured according to the known circuit values. However, the amplifier circuit may be implemented in a smaller circuit area, without a transformer, and the impedance circuitry may be distributed such that a portion of the impedance is provided by internal impedance values of the carrier amplifier and the peaking amplifier and their impedance matching circuitry and a portion is provided by impedance circuitry of one or more external circuits.

Embodiments of circuit devices are described below that implement a Doherty amplifier without an output transformer to enable smaller footprint, lower loss, and higher efficiency. Taking advantage of the properties of a ninety-degree/one hundred eighty-degree (90/180) Doherty, namely, the freedom to select the characteristic impedances of the 90-degree and 180-degree branches and the combining node impedance, the transformer between the combining node and the output may be eliminated. In one or more embodiments, the transformer may be eliminated by setting an impedance at the combining impedance to fifty ohms (50 Ω), enabling a selected impedance in a small, low-cost dual-flat no leads (DFN) lead frame package. In one or more embodiments, lower power level applications (for example, 128T and 64T applications) can enable elimination of the output transformer without a performance trade-off. For higher power level applications (such as 32T applications), embodiments of the circuit device may be applicable with a limited amplifier bandwidth.

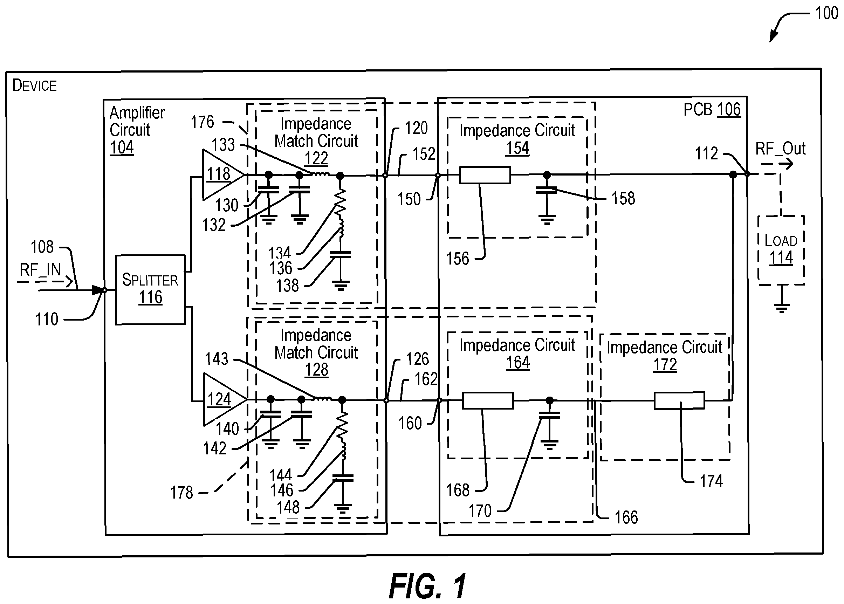

In one or more embodiments, the implementation of the first impedance, second impedance, and third impedance may include internal package match and external PCB match circuitry. In one or more embodiments, a generalized two-way compact Doherty power amplifier without an output transformer and with distributed impedance circuitry may be implemented as described below with respect to FIG. 1.

FIG. 1 depicts a diagram of a device 100 including an amplifier integrated circuit (IC) 104 and a printed circuit board 106 including impedance circuitry 154, 164, 172 configured to provide a Doherty amplifier device, in accordance with certain embodiments. The amplifier IC 104 may include an I/O terminal 110 configured to receive a radio frequency (RF) input signal 108 (RF_IN). The amplifier IC 104 may include a splitter circuit 116 including an input coupled to the I/O terminal 110, a first output coupled to an input of a carrier amplifier 118, and a second output coupled to an input of a peaking amplifier 124. The power splitter 102 may divide the RF input signal into two RF signals with equal or unequal power. The power splitter 116 or other circuitry at one or more of the outputs of the power splitter 116 may apply a phase shift to one or both of the two RF signals to achieve about a 90-degree phase difference between the two RF signals. The power splitter 116 may provide a first of the two RF signals to the carrier amplifier 118 and a second of the two RF signals to the peaking amplifier 124.

In one or more embodiments, the amplifier IC 104 may include an impedance match circuit 122 coupled between an output of the carrier amplifier 118 and an input/output (I/O) terminal 120. In one or more embodiments, the impedance match circuit 122 may include a capacitor 130 including a first terminal coupled to the output of the carrier amplifier 118 and a second terminal coupled to a reference voltage, such as ground. In one or more embodiments, the capacitor 130 may represent a drain-to-source capacitance of a transistor of the carrier amplifier 118. The impedance match circuit 122 may include a second capacitor 132 including a first terminal coupled to the output of carrier amplifier 118 and a second terminal coupled to a reference voltage, such as ground. The impedance match circuit 122 may include an inductor 133 including a first terminal coupled to the output of the carrier amplifier 118 and a second terminal coupled to the I/O terminal 120. The impedance match circuit 122 may include a resistor 134, an inductor 136, and a capacitor 138 coupled in series between the I/O terminal 120 and a reference voltage, such as ground.

In one or more embodiments, the amplifier IC 104 may include an impedance match circuit 128 coupled between an output of the peaking amplifier 124 and an I/O terminal 126. In one or more embodiments, the impedance match circuit 128 may include a capacitor 140 including a first terminal coupled to the output of the peaking amplifier 124 and a second terminal coupled to a reference voltage, such as ground. In one or more embodiments, the capacitor 140 may represent a drain-to-source capacitance of a transistor of the peaking amplifier 118. The impedance match circuit 128 may include a second capacitor 142 including a first terminal coupled to the output of the peaking amplifier 124 and a second terminal coupled to a reference voltage, such as ground. The impedance match circuit 128 may include an inductor 143 including a first terminal coupled to the output of the peaking amplifier 124 and a second terminal coupled to the I/O terminal 126. The impedance match circuit 128 may include a resistor 144, an inductor 146, and a capacitor 148 coupled in series between the I/O terminal 126 and a reference voltage, such as ground.

The amplifier circuit 104 may be coupled to a printed circuit board (PCB) 106 by a first wire trace 152 that extends between the I/O terminal 120 of the amplifier circuit 104 and an I/O terminal 150 of the PCB 106. The amplifier circuit 104 may be coupled to the PCB 106 by a second wire trace 162 that extends between the I/O terminal 126 of the amplifier circuit 104 and an I/O terminal 160 of the PCB 106.

The PCB 106 may include a first impedance circuit 154 coupled between the I/O terminal 150 and an I/O terminal 112, which may be coupled to a load 114, such as an antenna or another circuit element. The PCB 106 may include a second impedance circuit 164 coupled between the I/O terminal 160 and a node 166 and may include a third impedance circuit 172 coupled between the node 160 and the I/O terminal 112. In one or more embodiments, the carrier impedance (generally indicated at 176) is implemented with a series inductor, shunt-inductor internal match, a transmission line impedance element, and a shunt capacitor. Similarly, the peaking impedance (generally indicated at 178) is implemented with an internal series inductor, a shunt-capacitor internal match, a transmission line impedance element, and shunt capacitor. A third impedance 172 may couple the peaking impedance 178 to the combining node connected to the I/O terminal 112. The third impedance 172 may be implemented using a transmission line impedance element 174 (a ninety-degree transmission line). The lack of a transformer between the combining node and the I/O terminal 112 illustrates the compact footprint. The impedances 1176, 178, and 172 may combine to match the impedance of a load 114 coupled to the I/O terminal 112, providing reduced loss and leading to efficiency improvement.

It should be appreciated that the circuitry of the impedance circuits 154, 164, and 172 may vary, depending on the implementation. In one or more embodiments, the first impedance circuit 154 may include a transmission line impedance element 156 coupled in series between the I/O terminal 150 and the I/O terminal 112. The transmission line impedance element 156 may have a selected wavelength (e.g., a quarter wavelength (λ) or λ/4) to introduce a selected phase delay, such as a 90-degree phase delay. The first impedance circuit 154 may include a capacitor 158 including a first terminal coupled to the I/O terminal 112 and a second terminal coupled to a reference voltage, such as ground.

In one or more embodiments, the second impedance circuit 164 may include a transmission line impedance element 168 coupled in series between the I/O terminal 160 and the node 166. The transmission line impedance element 168 may have a selected wavelength to introduce a selected phase delay, such as 90-degrees. The second impedance circuit 164 may include a capacitor 170 including a first terminal coupled to the node 166 and a second terminal coupled to a reference voltage, such as ground.

In one or more embodiments, the third impedance circuit 172 may be coupled between the node 166 and the I/O terminal 112. The third impedance circuit 172 may include a transmission line impedance element 174. The transmission line impedance element 174 may have a selected wavelength to introduce a selected phase delay, such as 90-degrees.

In the illustrated example, the output signals from the carrier amplifier 118 and the peaking amplifier 124 may be combined at the I/O terminal to form the Doherty amplifier. The impedance circuits 154, 164, and 172 and the impedance match circuits 122 and 128 may cooperate to provide a selected impedance at the I/O terminal 112. In one or more embodiments, the selected impedance is, or is approximately, fifty ohms (50 Ω), which may match an impedance of a transmission line coupled to the I/O terminal 112 without an output transformer. The absence of the output transformer after the combining node (I/O terminal 112) may reduce the overall circuit footprint, reduce loss, and improve the efficiency of the power amplifier.

It should be understood that the impedance circuit 154 may cooperate with circuit elements of the impedance match circuit 122 (including, in some embodiments, circuitry of the carrier amplifier 118) to provide a first impedance to the combining node that is connected to the I/O terminal 112. The impedance circuit 164 may cooperate with circuit elements of the impedance match circuit 128 (including, in some embodiments, circuitry of the peaking amplifier 124) to provide a second impedance. The impedance circuit 172 may provide a third impedance that may cooperate with the second impedance to provide the peaking amplifier signal to the combining node that is connected to the I/O terminal 112. The first, second, and third impedances may be implemented with discrete passive circuit elements (i.e., inductors, capacitors, and resistors), transmission line impedance elements, or a combination thereof to provide an internal match inside the package of the amplifier IC 104 and/or an external match of the PCB 106.

For a set of characteristics of the carrier amplifier 118 and the peaking amplifier 124 and the selected peaking to carrier ratio, the carrier impedance 176 may be determined to reach a selected impedance at back-off operation when the impedance at the combining node (I/O node 112) is set to 50 ohms. Operation of the Doherty amplifier provided by the device 100 at power levels below the full-power output condition is referred to as "back-off operation." The peaking impedance 178 and the third impedance 172 may be determined to provide a selected Doherty peaking power and a selected trade-off between bandwidth and realizability of the internal and external matching elements. The carrier impedance 176 may be implemented, as shown, using a series and/or shunt inductor of an internal impedance match circuit 122 in conjunction with matching elements of the impedance circuit 154 using wires of a DFN lead frame package to connect to the combining node via the I/O terminal 112.

Similarly, the peaking impedance 178 may be implemented using series and/or shunt inductor of an internal impedance match circuit 128 in conjunction with matching elements of the impedance circuit 164 using wires of the DFN lead frame package to connect to the combining node via the I/O terminal 112. The third impedance 172 may connect the second impedance 176 to the combining node that is connected to the I/O terminal 112 may be implemented using wires, a capacitor-wire-capacitor connection, a c-bridge concept, or another connection.

Implementation of the previously described quarter wavelength (λ/4) transmission line(s) 156, 168, and 174 in the Doherty amplifier implemented by the device 100 may require placement of one or more lengthy and wide conductive paths on a mounting surface of a substrate. As such, each quarter wavelength (λ/4) transmission line 156, 168, and 174 may consume a significant amount of area on the mounting surface, which may impose limitations on the minimum footprint size of the amplifier circuit 104, if the Doherty amplifier were integrated in a die. By moving the transmission lines 156, 168, and 174 to the PCB 106, the overall footprint may be reduced.

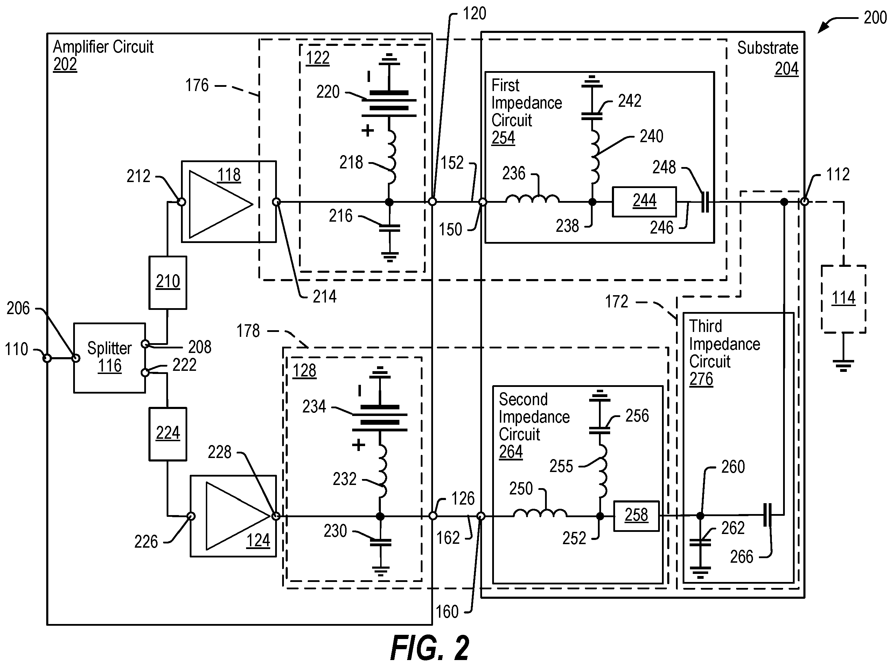

It should be understood that the embodiment of the device 100 represents one possible implementation but other implementations of the impedance circuits 156, 168, and 174 are also possible. An alternative embodiment of a Doherty amplifier is described below with respect to FIG. 2.

FIG. 2 depicts a diagram of a device 200 including an amplifier integrated circuit 202 and a substrate 204 including impedance circuitry configured to provide a Doherty amplifier device, in accordance with certain embodiments. The amplifier circuit 202 may include the splitter 116 including an I/O terminal 206 coupled to an I/O terminal 110 to receive an input signal. The splitter 116 may include a first I/O terminal 208 and a second I/O terminal 222. The first I/O terminal 208 may be coupled to an I/O terminal 212 of a carrier amplifier die 118 through an impedance matching circuit 210. The carrier amplifier die 118 may include an I/O terminal 214 that may be coupled to the I/O terminal 120 through an impedance match circuit 122.

In the illustrated example, the impedance match circuit 122 may include a capacitor 216 including a first terminal coupled to the I/O node 120 and a second terminal coupled to a reference voltage, such as ground. The impedance match circuit 122 may include an inductor 218 including a first terminal coupled to the I/O node 120 and a second terminal coupled to a supply voltage 220.

The second I/O terminal 222 may be coupled to an I/O terminal 226 of a peaking amplifier die 124 through an impedance matching circuit 224. The peaking amplifier die 124 may include an I/O terminal 228 that may be coupled to the I/O terminal 126 through an impedance match circuit 128.

In the illustrated example, the impedance match circuit 128 may include a capacitor 216 including a first terminal coupled to the I/O node 126 and a second terminal coupled to a reference voltage, such as ground. The impedance match circuit 128 may include an inductor 232 including a first terminal coupled to the I/O node 126 and a second terminal coupled to a supply voltage 234.

The substrate 204 may be a PCB or a lead frame. The substrate 204 may include an I/O terminal 150 coupled to the I/O terminal 120 by a wire trace 152. The substrate 204 may include a first impedance circuit 254. The first impedance circuit 254 may include an inductor 236 including a first terminal coupled to the I/O terminal 150 and a second terminal coupled to a node 238. The first impedance circuit 254 may include an inductor 240 including a first terminal coupled to the node 238 and a second terminal. The first impedance circuit 254 may include a capacitor 242 including a first terminal coupled to the second terminal of the inductor 240 and including a second terminal coupled to a reference voltage, such as ground. The first impedance circuit 254 may include a transmission line impedance element 244 including a first terminal coupled to the node 238 and a second terminal coupled to a node 246. The first impedance circuit 254 may include a capacitor 248 including a first terminal coupled to the node 246 and a second terminal coupled to the I/O terminal 112.

The substrate 204 may include an I/O terminal 160 coupled to the I/O terminal 126 by a wire trace 162. The substrate 204 may include a second impedance circuit 264. The second impedance circuit 264 may include an inductor 250 including a first terminal coupled to the I/O terminal 160 and a second terminal coupled to a node 252. The second impedance circuit 264 may include an inductor 255 including a first terminal coupled to the node 252 and a second terminal. The second impedance circuit 264 may include a capacitor 256 including a first terminal coupled to the second terminal of the inductor 255 and including a second terminal coupled to a reference voltage, such as ground. The second impedance circuit 264 may include a transmission line impedance element 258 including a first terminal coupled to the node 252 and a second terminal coupled to a node 260.

The substrate 204 may include a third impedance circuit 276 coupled between the node 260 and the I/O terminal 112. The third impedance circuit 276 may include a capacitor 262 including a first terminal coupled to the node 262 and a second terminal coupled to a reference voltage, such as ground. The third impedance circuit 276 may include a capacitor 266 including a first terminal coupled to the node 260 and including a second terminal coupled to the I/O terminal 112.

In this embodiment, as in the embodiment of FIG. 1, the first impedance 176, the second impedance 178, and the third impedance 172 may provide a selected impedance at the combining node that is connected to the I/O terminal 112. In one or more embodiments, the first impedance 176 may include circuit elements of the amplifier IC 204 and of the substrate 204. The second impedance 178 may include circuit elements of the amplifier IC 204 and of the substrate 204. The impedance at the I/O terminal 112 may be selected, and components of the first impedance circuit 254, the second impedance circuit 264, and third impedance circuit 276 may be selected to provide the selected impedance at the I/O terminal 112.

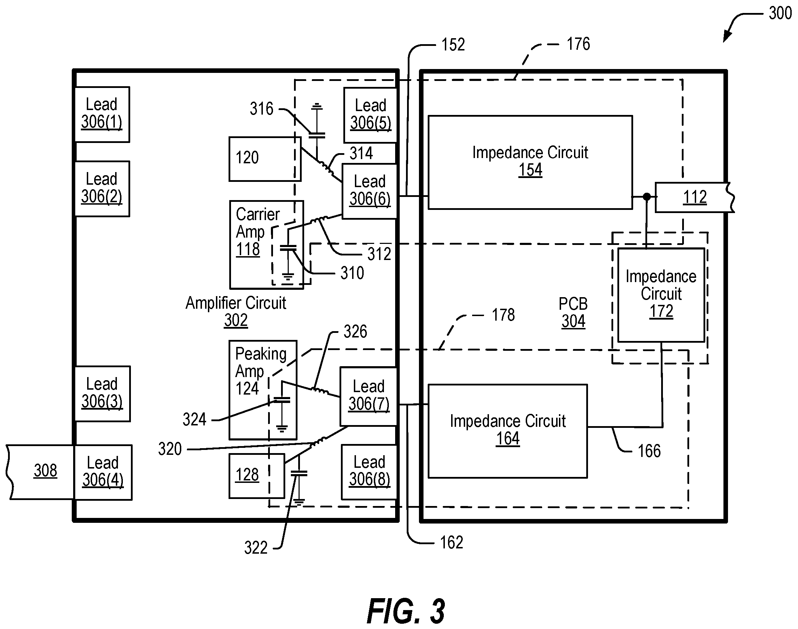

FIG. 3 depicts a diagram of a device 300 including an amplifier IC 302 coupled to a PCB 304 with impedance circuitry configured to provide a Doherty amplifier, in accordance with certain embodiments. The amplifier IC 302 may include leads 306, which may be coupled to one or more conductive traces. In the illustrated example, the lead 306(4) may be coupled to an I/O terminal 110. In this example, the splitter 116 is not shown; however, the splitter 116 may be included in the amplifier IC 302 or may be external to the amplifier IC 302.

The amplifier IC 302 may include the carrier amplifier die 118 and the peaking amplifier die 124, which may receive a divided RF signal according to a selected ratio. The carrier amplifier 118 may include a parasitic capacitance, which may be represented by a capacitor 310 including a first terminal and including a second terminal coupled to a reference voltage, such as ground. The first terminal of the capacitor 310 may be coupled to a first terminal of an inductor 312, which includes a second terminal coupled to the lead 306(6). The amplifier IC 302 may include an impedance match circuit 120, which may be coupled to the lead 306(6) by an inductor 314. The inductor 314 may include a first terminal coupled to the lead 306(6) and a second terminal coupled to the impedance match circuit 120. The amplifier IC 302 may include a capacitor 316 including a first terminal coupled to the second terminal of the inductor 314 and including a second terminal coupled to a reference voltage, such as ground.

The peaking amplifier 124 may include a parasitic capacitance, which may be represented by a capacitor 324 including a first terminal and including a second terminal coupled to a reference voltage, such as ground. The first terminal of the capacitor 324 may be coupled to a first terminal of an inductor 326, which includes a second terminal coupled to the lead 306(7). The amplifier IC 302 may include an impedance match circuit 128, which may be coupled to the lead 306(7) by an inductor 320. The inductor 320 may include a first terminal coupled to the lead 306(7) and a second terminal coupled to the impedance match circuit 128. The amplifier IC 302 may include a capacitor 322 including a first terminal coupled to the second terminal of the inductor 320 and including a second terminal coupled to a reference voltage, such as ground.

The PCB 304 may include a first impedance circuit 154 including an input coupled to the lead 306(6) by a wire trace 152 and including an output coupled to the I/O terminal 112 via a combining node. The first impedance circuit 154, the matching circuit 120, the carrier amplifier 118, and inductive and capacitive components may provide an effective first impedance from the carrier amplifier 118 to the I/O terminal 112. The PCB 304 may include a second impedance circuit 164 including an input coupled to the lead 306(7) by a wire trace 162 and including an output coupled to a node 166. The second impedance circuit 164, the matching circuit 128, the peaking amplifier 124, and inductive and capacitive components may provide an effective second impedance from the peaking amplifier 124 to the node 166.

The PCB 304 may include a third impedance circuit 172 coupled between the node 166 and the combining node. The effective second impedance 178 and the third impedance 172 may combine with the first impedance 176 to provide selected output impedance at the I/O node 112.

In the illustrated example, the impedance circuits 154, 164, and 172 may be integrated circuits or a set of discrete components mounted to the PCB 304. In one or more embodiments, the impedance circuits 154, 164, and 172 may be implemented on separated PCBs or may be integrated circuits mounted to a substrate. Other implementations are also possible.

In one or more embodiments, the first impedance circuit 154, the second impedance circuit 164, and the third impedance circuit 172 may be selected to operate in conjunction with circuit elements and parasitic characteristics of the amplifier IC 302 to provide a selected impedance at the I/O terminal 112. In this example, like the embodiments shown in FIGs. 1 and 2, the combining node may be connected directly to the I/O terminal 112 with no intervening transformer, thereby reducing the overall size of the Doherty amplifier device 300 relative to a conventional Doherty amplifier.

The embodiments described above with respect to FIGs. 1-3 may be configured to provide a 90/180 Doherty amplifier. In other implementations, the transmission line impedance elements may be omitted and the devices 100, 200, or 300 may be configured to implement a 0/90 Doherty amplifier. Further, the devices 100, 200, and 300 enable distributed impedance circuitry to provide a selected impedance at the I/O terminal 112, allowing for flexibility of a circuit device implementation. The device 100, 200, or 300 may provide a reduced device footprint and improved efficiency for 128T and 64T AAS system and for discrete AAS amplifier solutions.

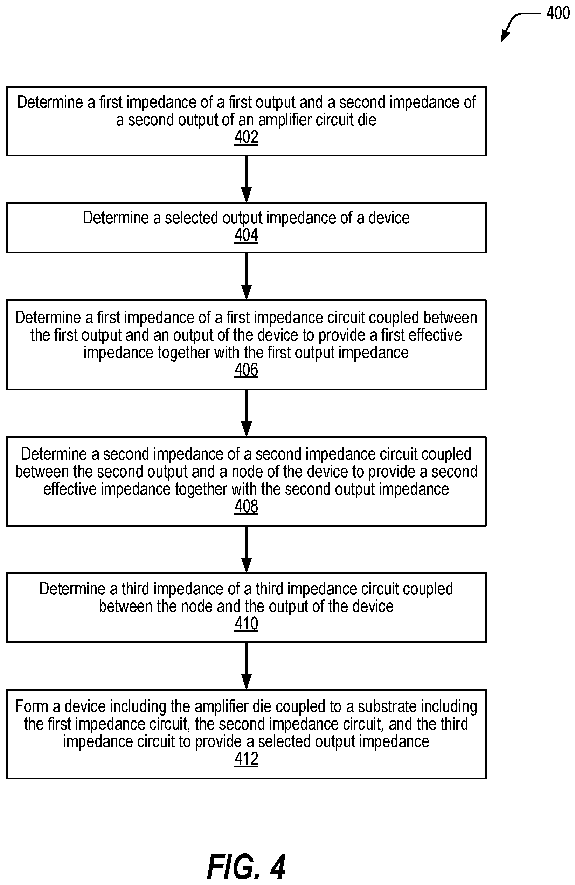

FIG. 4 depicts a flow diagram of a method 400 of designing a Doherty power amplifier including distributed impedance circuitry, in accordance with certain embodiments. At 402, the method 400 may include determining a first impedance of a first output and a second impedance of a second output of an amplifier circuit die. The first output may be coupled to an output of a carrier amplifier 118 and the second output may be coupled to an output of a peaking amplifier 124.

At 404, the method 400 may include determining a selected output impedance of a device. The selected output impedance may be a desired impedance at an I/O terminal 112 of a device. In one or more embodiments, the desired impedance may correspond to an impedance of a transmission line, a load 114, or another circuit. In one or more embodiments, the desired impedance may be fifty ohms (50 Ω).

At 406, the method 400 may include determining a first impedance of a first impedance circuit coupled between the first output and an output of the device to provide a first effective impedance together with the first output impedance. The first impedance circuit may include one or more of an inductor, a transmission line impedance element, or a capacitor configured to provide a selected impedance between the output of the carrier amplifier 118 and a combining node that is connected to the I/O terminal 112.

At 408, the method 400 may include determining a second impedance of a second impedance circuit coupled between the second output and a node of the device to provide a second effective impedance together with the second output impedance. The second impedance circuit may include one or more of an inductor, a transmission line impedance element, or a capacitor to provide a selected impedance between the output of the peaking amplifier 124 and a node 166.

At 410, the method 400 may include determining a third impedance of a third impedance circuit coupled between the node and the output of the device. The third impedance circuit may include one or more of an inductor, a transmission line impedance element, or a capacitor to provide a selected impedance between the node 166 and the combining node that is connected to the I/O terminal 112.

At 412, the method 400 may include forming a device including the amplifier die coupled to a substrate including the first impedance circuit, the second impedance circuit, and the third impedance circuit to provide a selected output impedance. The device may include a substrate that includes an amplifier IC coupled to the first impedance circuit and the second impedance circuit. The device may include the third impedance circuit coupled between the second impedance circuit and the I/O terminal 112.

In conjunction with the circuits and methods of FIGs. 1-4, a Doherty power amplifier may include an amplifier circuit including a first terminal and a second terminal and includes a printed circuit board (PCB) coupled to the first terminal and the second terminal. The PCB may include a first impedance circuit coupled between the first terminal and an output terminal, a second impedance circuit coupled between the second terminal and a node, and a third impedance circuit coupled between the node and the output terminal. The first impedance circuit and a portion of the amplifier circuit define a first impedance that corresponds to a selected output impedance at back-off operation. The second impedance circuit and a portion of the amplifier circuit define a second impedance. The first impedance, the second impedance, and a third impedance of the third impedance circuit operate with the amplifier IC to form a Doherty power amplifier with a selected output impedance.

This disclosure may be further understood in light of the following examples.

Example 1: A device includes an amplifier integrated circuit (IC) including a first amplifier including an output coupled to a first output terminal and a second amplifier including an output coupled to a second output terminal; and a printed circuit board (PCB) including a first input terminal coupled to the first output terminal, a second input terminal coupled to the second output terminal, and an output terminal, the PCB including: a first impedance circuit including an input coupled to the first input terminal and including an output coupled to a combining node that is connected to the output terminal; a second impedance circuit including an input coupled to the second input terminal and including an output coupled to a node; a third impedance circuit including an input coupled to the node and including an output coupled to a combining node that is connected to the output terminal of the PCB; where an output impedance at the output terminal of the PCB is determined by: a first impedance provided, at least in part, by the first impedance circuit and parasitic characteristics of the first amplifier and associated wire traces; a second impedance provided, at least in part, by the second impedance circuit and parasitic characteristics of the second amplifier and associated wire traces; and a third impedance provide by the third impedance circuit.

Example 2: The device of Example 1, where the output impedance matches one of a transmission line impedance and a load impedance.

Example 3: The device of any of Examples 1-2, where the amplifier IC includes the first amplifier including a first input to receive a first radio frequency (RF) signal and a first output to provide a first amplified signal; and the second amplifier including a second input to receive a second RF signal and a second output to provide a second amplified signal.

Example 4: The device of any of Examples 1-3, where the first impedance is configured to provide a ninety-degree phase adjustment; the second impedance is configured to provide a ninety-degree phase adjustment; and the third impedance circuit is configured to provide a negative ninety-degree phase adjustment; where the second impedance has a zero-degree phase offset relative to a peaking amplifier output signal; and where the Doherty power amplifier circuit includes a ninety-one hundred eighty (90° -180°) Doherty amplifier.

Example 5: The device of any of Examples 1-4, where the first impedance is configured to provide the output impedance at back-off operation.

Example 6: The device of any of Examples 1-5, where the first impedance circuit includes at least one of a first capacitor, a first inductor, and a first transmission line impedance element; and the second impedance circuit includes at least one of a second capacitor, a second inductor, and a second transmission line impedance element.

Example 7: The device of any of Examples 1-6, where the amplifier IC includes an input terminal configured to receive a radio frequency (RF) input signal; a splitter circuit including an input coupled to the input terminal, a first output coupled to an input of the first amplifier to provide a first RF signal; and a second output coupled to an input of the second amplifier to provide a second RF signal; and where the splitter defines a power ratio between the first RF signal and the second RF signal.

Example 8: The device of Example 7, where the amplifier IC further includes a first matching circuit coupled between the first output of the first amplifier and the first output terminal of the amplifier IC; a second matching circuit coupled between the second output of the second amplifier and the second output terminal of the amplifier IC; and where a first matching impedance of the first matching circuit contributes to the first impedance; and where the second matching impedance of the second matching circuit contributes to the second impedance.

Example 9: The device of Example 8, where the first matching circuit includes: a first capacitor including a first terminal coupled to the first output terminal and a second terminal coupled to a reference voltage; a first inductor including a first terminal coupled to the first output terminal and including a second terminal; a second capacitor including a first terminal coupled to the second terminal of the first inductor and including a second terminal coupled to the reference voltage; and the second matching circuit includes: a third capacitor including a first terminal coupled to the second output terminal and a second terminal coupled to the reference voltage; a second inductor including a first terminal coupled to the second output terminal and including a second terminal; and a fourth capacitor including a first terminal coupled to the second terminal of the second inductor and including a second terminal coupled to the reference voltage.

Example 10: The device of Example 8, where the first matching circuit includes: a first capacitor including a first terminal coupled to the output of the first amplifier and including a second terminal coupled to a reference voltage; a first inductor including a first terminal coupled to the output of the first amplifier and including a second terminal coupled to the first output terminal; a resistor including a first resistor terminal coupled to the first output terminal and including a second resistor terminal; a second inductor including a first terminal coupled to the second resistor terminal and including a second terminal; and a second capacitor including a first terminal coupled to the second terminal of the second inductor and including a second terminal coupled to the reference voltage; and the second matching circuit includes: a third capacitor including a first terminal coupled to the output of the second amplifier and including a second terminal coupled to the reference voltage; third inductor including a first terminal coupled to the output of the second amplifier and including a second terminal coupled to the second output terminal; a second resistor including a third resistor terminal coupled to the second output terminal and including a fourth resistor terminal; a fourth inductor including a first terminal coupled to the fourth resistor terminal and including a second terminal; and a fourth capacitor including a first terminal coupled to the second terminal of the fourth inductor and including a second terminal coupled to the reference voltage.

Example 11: The device of Example 8, where the first matching circuit includes: a first inductor including a first terminal coupled to the output of the first amplifier and including a second terminal coupled to the first output terminal; a first capacitor including a first terminal coupled to the output of the first amplifier and including a second terminal coupled to the reference voltage; and the second matching circuit includes: a second inductor including a first terminal coupled to the output of the second amplifier and including a second terminal coupled to the second output terminal; and a second capacitor including a first terminal coupled to the second terminal of the fourth inductor and including a second terminal coupled to the reference voltage.

Example 12: A method including determining a first amplifier impedance at a first output terminal of an amplifier integrated circuit (IC); determining a second amplifier impedance at a second output terminal of the amplifier IC; determining a selected output impedance; determining a first impedance of a first impedance circuit of printed circuit board (PCB), the first impedance circuit configured to couple the first output terminal to a combining node of the PCB, where the combining node is connected to an output terminal of the PCB; determining a second impedance of a second impedance circuit of the PCB, the second impedance circuit configured to couple the second output terminal to a node of the PCB; determining a third impedance of a third impedance circuit of the PCB, the third impedance circuit coupled between the node and the combining node; producing the PCB including the first impedance circuit, the second impedance circuit, the third impedance circuit, the node, the combining node, and the output terminal; and coupling the PCB to the amplifier IC to produce a Doherty power amplifier.

Example 13: The method of Example 12, where determining the first impedance includes determining a first effective resistance based at least in part on the first amplifier impedance and the first impedance such that the first effective impedance achieves the selected output impedance at back-off operation.

Example 14: The method of Example 13, where determining the second impedance includes determining a second effective impedance based at least in part on the second amplifier impedance and the second impedance; and determining the third impedance includes determining a third impedance based on the second impedance to provide the output impedance in conjunction with the first impedance.

Example 15: The method of any of Examples 12-14, where, during operation, the method further includes: receiving a radio frequency (RF) input signal at the amplifier IC; splitting the RF input signal into a first RF signal and a second RF signal; providing the first RF signal to an input of a first amplifier that includes an output coupled to the first output terminal to provide a first amplified RF signal; providing the second RF signal to an input of a second amplifier that includes an output coupled to the second output terminal to provide a second amplified RF signal; applying the first impedance to the first amplified RF signal to provide a first portion of an output signal; applying the second impedance and the third impedance to the second amplified RF signal to provide a second portion of the output signal; combining the first portion and the second portion to produce the output signal at a combing node; and providing the output signal to the output terminal.

Example 16: A device includes an amplifier integrated circuit (IC) including a first amplifier including an output coupled to a first output terminal and a second amplifier including an output coupled to a second output terminal; and a substrate including a first input terminal coupled to the first output terminal, a second input terminal coupled to the second output terminal, and an output terminal, the substrate including: a first impedance circuit including an input coupled to the first input terminal and including an output coupled to a combining node that is connected to the output terminal; a second impedance circuit including an input coupled to the second input terminal and including an output coupled to a node; a third impedance circuit including an input coupled to the node and including an output coupled to a combining node that is connected to the output terminal of the substrate; where an output impedance at the output terminal of the substrate is determined by: a first impedance provided, at least in part, by the first impedance circuit and parasitic characteristics of the first amplifier and associated wire traces; a second impedance provided, at least in part, by the second impedance circuit and parasitic characteristics of the second amplifier and associated wire traces; and a third impedance provide by the third impedance circuit.

Example 17: The device of Example 16, where the output impedance matches one of a transmission line impedance and a load impedance.

Example 18: The device of any of Examples 16-17, where the amplifier IC includes the first amplifier including a first input to receive a first radio frequency (RF) signal and a first output to provide a first amplified signal; and the second amplifier including a second input to receive a second RF signal and a second output to provide a second amplified signal.

Example 19: The device of Example 18, where the amplifier IC further includes a first matching circuit coupled between the first output of the first amplifier and the first output terminal of the amplifier IC; a second matching circuit coupled between the second output of the second amplifier and the second output terminal of the amplifier IC; and where a first matching impedance of the first matching circuit contributes to the first impedance; and where the second matching impedance of the second matching circuit contributes to the second impedance.

Example 20: The device of Example 18, where the amplifier IC further includes a first matching circuit includes: a first inductor including a first terminal coupled to the output of the first amplifier and including a second terminal coupled to the first output terminal; a first capacitor including a first terminal coupled to the output of the first amplifier and including a second terminal coupled to the reference voltage; and a second matching circuit includes: a second inductor including a first terminal coupled to the output of the second amplifier and including a second terminal coupled to the second output terminal; and a second capacitor including a first terminal coupled to the second terminal of the fourth inductor and including a second terminal coupled to the reference voltage.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

## Claims

1. A device comprises:
an amplifier integrated circuit, IC, including a first amplifier including an output coupled to a first output terminal and a second amplifier including an output coupled to a second output terminal; and
a printed circuit board, PCB, including a first input terminal coupled to the first output terminal, a second input terminal coupled to the second output terminal, and an output terminal, the PCB comprising:
a first impedance circuit including an input coupled to the first input terminal and including an output coupled to a combining node that is connected to the output terminal;
a second impedance circuit including an input coupled to the second input terminal and including an output coupled to a node;
a third impedance circuit including an input coupled to the node and including an output coupled to a combining node that is connected to the output terminal of the PCB;
wherein an output impedance at the output terminal of the PCB is determined by:
a first impedance provided, at least in part, by the first impedance circuit and parasitic characteristics of the first amplifier and associated wire traces;
a second impedance provided, at least in part, by the second impedance circuit and parasitic characteristics of the second amplifier and associated wire traces; and
a third impedance provide by the third impedance circuit.

2. The device of claim 1, wherein the output impedance matches one of a transmission line impedance and a load impedance.

3. The device of claim 1 or 2, wherein the amplifier IC comprises:
the first amplifier including a first input to receive a first radio frequency (RF) signal and a first output to provide a first amplified signal; and
the second amplifier including a second input to receive a second RF signal and a second output to provide a second amplified signal.

4. The device of any preceding claim, wherein:
the first impedance is configured to provide a ninety-degree phase adjustment;
the second impedance is configured to provide a ninety-degree phase adjustment; and
the third impedance circuit is configured to provide a negative ninety-degree phase adjustment;
wherein the second impedance has a zero-degree phase offset relative to a peaking amplifier output signal; and
wherein the Doherty power amplifier circuit comprises a ninety-one hundred eighty (90° -180°) Doherty amplifier.

5. The device of any preceding claim, wherein the first impedance is configured to provide the output impedance at back-off operation.

6. The device of any preceding claim, wherein:
the first impedance circuit comprises at least one of a first capacitor, a first inductor, and a first transmission line impedance element; and
the second impedance circuit comprises at least one of a second capacitor, a second inductor, and a second transmission line impedance element.

7. The device of any preceding claim, wherein the amplifier IC comprises:
an input terminal configured to receive a radio frequency (RF) input signal;
a splitter circuit including an input coupled to the input terminal, a first output coupled to an input of the first amplifier to provide a first RF signal; and a second output coupled to an input of the second amplifier to provide a second RF signal; and
wherein the splitter defines a power ratio between the first RF signal and the second RF signal.

8. The device of claim 7, wherein the amplifier IC further comprises:
a first matching circuit coupled between the first output of the first amplifier and the first output terminal of the amplifier IC;
a second matching circuit coupled between the second output of the second amplifier and the second output terminal of the amplifier IC; and
wherein a first matching impedance of the first matching circuit contributes to the first impedance; and
wherein the second matching impedance of the second matching circuit contributes to the second impedance.

9. The device of claim 8, wherein:
the first matching circuit comprises:
a first capacitor including a first terminal coupled to the first output terminal and a second terminal coupled to a reference voltage;
a first inductor including a first terminal coupled to the first output terminal and including a second terminal;
a second capacitor including a first terminal coupled to the second terminal of the first inductor and including a second terminal coupled to the reference voltage; and
the second matching circuit comprises:
a third capacitor including a first terminal coupled to the second output terminal and a second terminal coupled to the reference voltage;
a second inductor including a first terminal coupled to the second output terminal and including a second terminal; and
a fourth capacitor including a first terminal coupled to the second terminal of the second inductor and including a second terminal coupled to the reference voltage.

10. The device of claim 8, wherein:
the first matching circuit comprises:
a first capacitor including a first terminal coupled to the output of the first amplifier and including a second terminal coupled to a reference voltage;
a first inductor including a first terminal coupled to the output of the first amplifier and including a second terminal coupled to the first output terminal;
a resistor including a first resistor terminal coupled to the first output terminal and including a second resistor terminal;
a second inductor including a first terminal coupled to the second resistor terminal and including a second terminal; and
a second capacitor including a first terminal coupled to the second terminal of the second inductor and including a second terminal coupled to the reference voltage; and
the second matching circuit comprises:
a third capacitor including a first terminal coupled to the output of the second amplifier and including a second terminal coupled to the reference voltage;
third inductor including a first terminal coupled to the output of the second amplifier and including a second terminal coupled to the second output terminal;
a second resistor including a third resistor terminal coupled to the second output terminal and including a fourth resistor terminal;
a fourth inductor including a first terminal coupled to the fourth resistor terminal and including a second terminal; and
a fourth capacitor including a first terminal coupled to the second terminal of the fourth inductor and including a second terminal coupled to the reference voltage.

11. The device of claim 8, wherein:
the first matching circuit comprises:
a first inductor including a first terminal coupled to the output of the first amplifier and including a second terminal coupled to the first output terminal;
a first capacitor including a first terminal coupled to the output of the first amplifier and including a second terminal coupled to the reference voltage; and
the second matching circuit comprises:
a second inductor including a first terminal coupled to the output of the second amplifier and including a second terminal coupled to the second output terminal; and
a second capacitor including a first terminal coupled to the second terminal of the fourth inductor and including a second terminal coupled to the reference voltage.

12. A method comprising:
determining a first amplifier impedance at a first output terminal of an amplifier integrated circuit, IC;
determining a second amplifier impedance at a second output terminal of the amplifier IC;
determining a selected output impedance;
determining a first impedance of a first impedance circuit of printed circuit board, PCB, the first impedance circuit configured to couple the first output terminal to a combining node of the PCB, wherein the combining node is connected to an output terminal of the PCB;
determining a second impedance of a second impedance circuit of the PCB, the second impedance circuit configured to couple the second output terminal to a node of the PCB;
determining a third impedance of a third impedance circuit of the PCB, the third impedance circuit coupled between the node and the combining node;
producing the PCB including the first impedance circuit, the second impedance circuit, the third impedance circuit, the node, the combining node, and the output terminal; and
coupling the PCB to the amplifier IC to produce a Doherty power amplifier.

13. The method of claim 12, wherein determining the first impedance comprises determining a first effective resistance based at least in part on the first amplifier impedance and the first impedance such that the first effective impedance achieves the selected output impedance at back-off operation.

14. The method of claim 13, wherein:
determining the second impedance comprises determining a second effective impedance based
at least in part on the second amplifier impedance and the second impedance; and determining the third impedance comprises determining a third impedance based on the second
impedance to provide the output impedance in conjunction with the first impedance.

15. The method of any of claims 12 to 14, wherein, during operation, the method further comprises:
receiving a radio frequency, RF, input signal at the amplifier IC;
splitting the RF input signal into a first RF signal and a second RF signal;
providing the first RF signal to an input of a first amplifier that includes an output coupled to the first output terminal to provide a first amplified RF signal;
providing the second RF signal to an input of a second amplifier that includes an output coupled to the second output terminal to provide a second amplified RF signal;
applying the first impedance to the first amplified RF signal to provide a first portion of an output signal;
applying the second impedance and the third impedance to the second amplified RF signal to provide a second portion of the output signal;
combining the first portion and the second portion to produce the output signal at a combing node; and
providing the output signal to the output terminal.
